# EUROPÄISCHE PATENTSCHRIFT

(11) **EP 2 689 645 B1**
(45) Veröffentlichungstag und Bekanntmachung des Hinweises auf die Patenterteilung: **04.09.2019**
(21) Anmeldenummer: 12709614.7
(22) Anmeldetag: 14.03.2012
(51) Int. Cl.: H05K 3/46, B65H 29/32, B65H 35/00, B65H 31/10

(54) **VERFAHREN ZUR HERSTELLUNG EINES FOLIENSTAPELS UND ANLAGE ZUR HERSTELLUNG EINES FOLIENSTAPELS**
METHOD FOR PRODUCING A FILM STACK, AND SYSTEM FOR PRODUCING A FILM STACK
PROCÉDÉ DE FABRICATION D'UN EMPILEMENT DE FILMS ET INSTALLATION POUR LA FABRICATION D'UN EMPILEMENT DE FILMS

(30) Priorität: 21.03.2011 DE 102011014583
(43) Veröffentlichungstag der Anmeldung: 29.01.2014
(73) Patentinhaber: TDK Electronics AG, 81671 München (DE)
(72) Erfinder: WEILHARTER, Josef, A-8524 Bad Gams (AT); KEHRER, Oskar, A-8044 Graz (AT)
(74) Vertreter: Epping - Hermann - Fischer
(86) Internationale Anmeldenummer: PCT/EP2012/054481
(87) Internationale Veröffentlichungsnummer: WO 2012/126787

(56) Entgegenhaltungen:
- GB-A- 2 251 516
- US-A- 5 412 865

## Beschreibung

Die Erfindung betrifft ein Verfahren zur Herstellung eines Folienstapels und eine Anlage zur Herstellung eines Folienstapels. Solch ein Folienstapel kann ein Zwischenprodukt bei der Herstellung elektronischer Bauelemente sein und beispielsweise Keramikfolien, wie Grünkeramikfolien, umfassen.

Folienstapel umfassen aufeinander geschichtete Folienblätter. Folienstapel können durch händische beziehungsweise manuelle oder automatisierte Verfahren hergestellt werden. Nachteil der händischen Stapelherstellung ist das mögliche Beschädigen der oft sehr dünnen und empfindlichen Folien durch das Handling, wobei Risse, Beulen, Druckstellen, Perforationen, umgeknickte Kanten, Verschiebungen der Folien usw. entstehen können. Die Abfolge der Folienblätter im Stapel kann sehr komplex sein, was Training und eine lang anhaltende und hohe Konzentration der stapelnden Person erfordert. Nichtsdestotrotz ist die Gefahr von Stapelfehlern durch das Abstapeln einer falschen Folienblattreihenfolge gegeben. Bei händischen Verfahren kann der Ausschuss relativ hoch sein.

Automatisierte Abstapelsysteme haben eine aufwändige Prozesstechnik, um die Folienblätter vor dem eigentlichen Abstapeln auszurichten. Dabei muss die Istposition des Folienblatts mit hochgenauen Visionsystemen über Fiducials bzw. Zentriermarken erfasst und durch hochgenaue Ausrichttische in die benötigte Sollposition zum lagerichtigen Abstapeln gebracht werden. Zusätzlich ist das Abstapeln dünner Folien gleich oder kleiner 120 pm, insbesondere gleich oder kleiner 60 µm, nur eingeschränkt beziehungsweise überhaupt nicht möglich.

Ein weiteres Verfahren zum automatischen Abstapeln sieht vor, dass die Folie direkt in eine Abstapelform gestanzt wird. Nachteilig wirkt sich dabei aus, dass dadurch Stanzschnipsel leicht mit in die Abstapelform gelangen können, was zu Qualitätsmängeln und Ausschuss führen kann.

In der GB 2 251 516 A wird ein Verfahren zur Herstellung eines Folienstapels beschrieben, bei dem ein Folienblatt ausgestanzt wird, mittels einer Trägerplatte gehalten und auf einem freistehenden Folienstapel abgelegt wird. Die Ausrichtung beim Ablegen erfolgt mittels Positionsmarken auf dem Folienblatt.

In der US 5 412 865 A wird ein Verfahren zur Herstellung eines Folienstapels beschrieben, bei dem eine Stapelform vorgesehen ist, in der der Folienstapel aufgeschichtet wird. Der Boden der Stapelform ist beweglich. Das Stapeln erfolgt, indem in einem kombinierten Ablage- und Ausstanzschritt die Folie auf den angehobenen Stapel gepresst und gleichzeitig mittels der Kanten der Stapelform das aufgelegte Blatt abgetrennt wird.

Es stellt sich die Aufgabe ein verbessertes Verfahren anzugeben, um einen Stapel aus bedruckten und unbedruckten Folien, insbesondere Grünkeramikfolien, in einer gewünschten variablen Höhe mit einer hohen Stapelgenauigkeit und Qualität herzustellen. Zudem soll eine entsprechende Anlage zur Herstellung eines Stapels angegeben werden.

Die Aufgabe wird durch die in den nebengeordneten Patentansprüchen angegebenen Maßnahmen gelöst. Weitere vorteilhafte Ausgestaltungen sind in den untergeordneten Patentansprüchen angegeben.

Das Verfahren zur Herstellung eines Folienstapels umfasst: Bereitstellen von Folie, Heraustrennen eines Folienblatts aus der Folie, indem das Folienblatt aus der Folie auf eine Trägerplatte gestanzt wird, sodass das Folienblatt in einer vorgegebenen Position auf der Trägerplatte positioniert wird, Halten des Folienblatts auf der Trägerplatte in der vorgegebenen Position, Bewegen der Trägerplatte mit dem gehaltenen Folienblatt über eine Stapelform, wobei das Folienblatt in der vorgegebenen Position verbleibt, Bewegen eines höhenverstellbaren Bodens der Stapelform in Richtung der Trägerplatte, wobei abgestapelte Folienblätter in der Stapelform auf das gehaltene Folienblatt zubewegt werden bis die abgestapelten Folienblätter das gehaltene Folienblatt berühren, Ablegen des Folienblatts in die Stapelform.

Diese Schritte werden mehrfach wiederholt, dass die in der Stapelform abgestapelten Folienblätter einen Folienstapel bilden.

Die vorgegebene Position ist derart, dass das Folienblatt aus dieser Position genau in der Stapelform beziehungsweise kantengenau auf die abgestapelten Folienblätter in der Stapelform abgelegt werden kann, nachdem die Trägerplatte über die Stapelform bewegt worden ist.

Das Verfahren ermöglicht, einen Stapel aus bedruckten und unbedruckten Folienblättern, insbesondere Grünkeramikfolienblättern, in einer gewünschten variablen Höhe mit einer hohen Stapelgenauigkeit und Qualität herzustellen. Die Abfolge der Folienblätter im Stapel (gedreht, nicht gedreht, bedruckt, unbedruckt, als Sicherheitslayer ausgebildet usw.) kann dabei frei gewählt werden.

Der Heraustrennen kann vorteilhafterweise mittels Stanzen erfolgen, aber auch andere Trennverfahren, z.B. mittels Laser, sind denkbar. Das Stanzen kann derart erfolgen, dass das Folienblatt aus der Folie auf die Trägerplatte gestanzt wird, sodass Heraustrennen und Ablegen in einem Schritt erfolgen. Es ist auch denkbar Stanzen und Ablegen beim Heraustrennen in aufeinander folgenden Schritten auszuführen.

Das abzustapelnde Folienblatt wird ab dem Trennschritt, der beispielsweise Ausstanzen vorsieht, auf der Trägerplatte festgehalten und verändert seine Position bis zum Abstapeln in die Stapelform nicht mehr. Damit fallen aufwändige Prozessschritte zum Ausrichten weg. Zentriermarken für ein solches Ausrichten sind nicht erforderlich. Weitere Verarbeitungsschritte zwischen Trennen, beispielsweise durch Ausstanzen, und Ablegen erfolgen auf der Trägerplatte ohne dass die Position des Folienblatts verändert wird. Solche Schritte können beispielsweise Bedrucken, Trocknen der Bedruckung, Kontrollieren der Bedruckung mit einem Visionsystem sein.

Vorteilhafterweise wird das Folienblatt durch Unterdruck auf der Trägerplatte in seiner vorgegebenen Position gehalten, beispielsweise mittels Unterdruck- oder Vakuumdüsen in der Trägerplatte oder durch Verwendung eines offenporigen, porösen Materials als Trägerplatte. Zum Schutz des Folienblatts und zur Verweidung der Verschmutzung der Trägerplatte kann ein Luft durchlässiges, leicht wechselbares Papier auf der Trägerplatte fixiert sein, beispielsweise mittels Randverklebung.

Der Boden der Stapelform ist in einer Ausführung höhenverstellbar und wird in Richtung der Trägerplatte bewegt, d.h. angehoben, sodass die bereits abgestapelten Folienblätter mit dem von der Trägerplatte gehaltene Folienblatt in Kontakt gebracht werden. Mit anderen Worten: die abgestapelten Folienblätter werden in der Stapelform auf das von der Trägerplatte gehaltene Folienblatt zubewegt bis die abgestapelten Folienblätter das gehaltene Folienblatt berühren. Somit kann das Folienblatt beim Auflegen auf die abgestapelten Folienblätter nicht seine Position verändern, sodass die Folienblätter im Stapel exakt ausgerichtet sind und deren Kanten übereinander liegen.

Beim Ablegen wird Überdruck zwischen der Trägerplatte und dem Folienblatt eingebracht, beispielsweise durch Druckluft. Dadurch wird das Folienblatt von der Trägerplatte gelöst.

Der Boden der Stapelform wird nach dem Ablegen des Folienblatts abgesenkt, um das Folienplatt von der Trägerplatte wegzubewegen. Beim Ablegen hat das Folienblatt keine Fallhöhe zu überwinden, was Verschiebungen des Folienblatts beim Ablegen verhindert.

Der Boden wird nach dem Anheben um dieselbe Wegstrecke, die er angehoben wird, um die abgestapelten Folienblätter in Richtung der Trägerplatte zu bewegen, sowie die Dicke des Folienblatts wieder abgesenkt, sodass die Oberseite der abgestapelten Folienblätter zwischen den Ablegevorgängen in einer vorgegebenen Position relativ zur Oberseite der Stapelform sind, unabhängig von der Höhe der bereits abgestapelten Folienblätter.

Ein erstes Hubmodul kann den Boden um die Wegstrecke anheben und absenken, und ein zweites Hubmodul kann den Boden, schrittweise jeweils, um die Dicke des Folienblatts absenken.

Zwischen den Abstapelvorgängen kann die Stapelform um eine Längsachse gedreht werden, vorteilhafterweise um 90°, 180° oder 270°. Dies ermöglicht gleiche Folien in verschiedener Ausrichtung abzulegen.

Eine Anlage zur Herstellung eines Folienstapels umfasst eine Trennvorrichtung zum Heraustrennen eines Folienblatts aus einer Folie, indem das Folienblatt aus der Folie auf eine Trägerplatte gestanzt wird, sowie eine Stapelform mit höhenverstellbarem Boden, dessen Grundfläche mit der des Folienblatts korrespondiert. Die Trägerplatte ist geeignet, das ausgestanzte Folienblatt in einer vorgegebenen Position auf der Trägerplatte zu halten, und kann von der Trennvorrichtung in eine Position über der Stapelform bewegt werden, um das Folienblatt zum Abstapeln zu transportieren. Der höhenverstellbare Boden der Stapelform ist in Richtung der Trägerplatte derart bewegbar, dass die abgestapelte Folienblätter in der Stapelform auf das gehaltene Folienblatt zubewegt werden bis die abgestapelten Folienblätter das gehaltene Folienblatt berühren.

Die Anlage, mit der das Verfahren ausgeführt wird, hat geringen Platz- und Flächenbedarf.

Die Trennvorrichtung kann als Stanzvorrichtung ausgebildet sein. In einem Ausführungsbeispiel wird das Folienblatt in die vorgegebene Position auf der Trägerplatte gestanzt.

Die Trägerplatte ist in einer Ausführung ausgebildet, das Folienblatt durch Unterdruck zu halten, beispielsweise durch Vakuum- oder Unterdruckdüsen. Ferner ist Trägerplatte in einer Ausführung ausgebildet, dass Folienblatt durch Überdruck von der Trägerplatte zu lösen, beispielsweise durch Düsen, die zwischen Unterdruck beziehungsweise Vakuum und Druckluft umschaltbar sind. In einem Ausführungsbeispiel sind sowohl Vakuum- oder Unterdruckdüsen als auch Druckluftdüsen vorgesehen.

Ein erstes Hubmodul ist vorgesehen, um den Boden um eine Wegstrecke anzuheben und absenken, und ein zweites Hubmodul ist vorgesehen, um den Boden schrittweise jeweils um die Dicke des Folienblatts abzusenken. Das erste Hubmodul kann einen Kurzhubzylinder, beispielsweise einen Pneumatikkurzhubzylinder, umfassen, und das zweite Hubmodul kann einen Servomotor umfassen.

Die Stapelform kann um eine Längsachse drehbar sein, beispielsweise mittels eines Drehtellers. Damit die Folienblätter nicht verkanten, hat die Stapelform eine mit einer Fase versehene Innenkante.

Nachfolgend wird die Erfindung unter Bezugnahme auf die Zeichnung anhand von Ausführungsbeispielen erklärt.

Die Figur 1 zeigt schematisch ein Ausführungsbeispiel einer Anlage zur Herstellung eines Folienstapels.

Die Figur 2 zeigt schematisch ein Ausführungsbeispiel einer Trennvorrichtung.

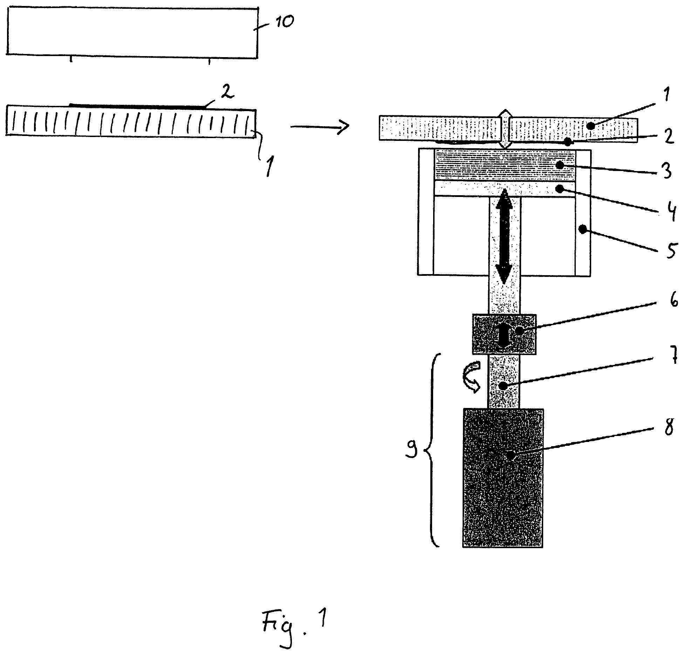

Die in der Figur 1 veranschaulichte Anlage umfasst eine bewegliche Trägerplatte 1 mittels derer ein Folienblatt 2, vorzugsweise aus einer Keramikfolie, insbesondere aus Grünkeramikfolie, wie sie in elektronischen Bauelementen verwendet wird, gehalten wird. Die Trägerplatte 1 kann als Metallplatte ausgebildet sein.

In der Trägerplatte 1 können Öffnungen oder Düsen vorgesehen sein, an denen Luft angesaugt und/oder aus denen Druckluft abgegeben werden kann. Die Öffnungen sind im Bereich vorgesehen, in dem das Folienblatt 2 gehalten wird. Das Halten erfolgt durch Unterdruck beziehungsweise Vakuum, welches entsteht, wenn in den Öffnungen der Druck reduziert wird. Wird aus den Öffnungen Druckluft abgegeben, löst sich das Folienblatt 2 von der Trägerplatte 1.

Es ist ein Stanzkopf 10 als Trennvorrichtung vorgesehen, mit dem das Folienblatt 2 aus einer Folie gestanzt wird. Das Prinzip ist schematisch in Figur 1 veranschaulicht. Während des Austanzens sind die Trägerplatte 2 und der Stanzkopf benachbart.

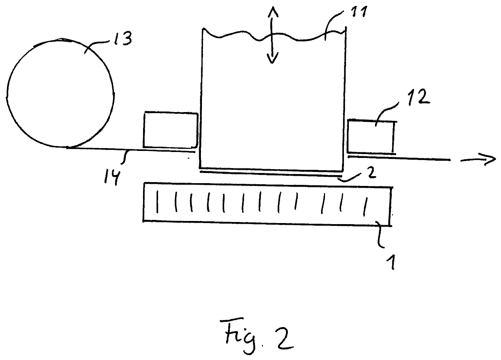

Figur 2 zeigt ein Ausführungsbeipiel einer Trennvorrichtung mit einem Stanzstempel 11 und einer Matrize 12. Die Matrize 12 hat eine Öffnung, die mit der Größe der Unterseite des Stanzstempels 11 und des Folienblattes 2 korrespondiert und durch die sich der Stanzstempel 11 beim Stanzvorgang bewegt. Stanzstempel 11, Matrize 12 und Trägerplatte 1 können mit kombinierten Vakuum-Druckluft-Düsen (nicht dargestellt) versehen sein, die zwischen Druckluft und Vakuum umschaltbar sind. Die Folie 14 kann beispielsweise über eine Folienrolle 13 zugeführt werden, sodass sie vor dem Stanzen zwischen Stanzstempel 11 beziehungsweise Matrize 12 und Trägerplatte 1 positioniert ist. Die bahnförmige Folie 14 kann über die Düsen, an denen Luft angesaugt wird, an der Matrize 12 und am Stanzstempel 11 gehalten werden. Der Stanzstempel 11 stanzt das Folienblatt 2 aus der Folie 14 aus und die Düsen am Stanzstempel 11 werden zum Lösen des Folienblatt 2 auf Druckluft umgeschaltet, sodass das Folienblatt 2 in einer vorgegebenen Position auf der Trägerplatte 1 positioniert wird. Nach dem Stanzen wird der Bereich, aus dem das Folienblatt 2 gestanzt worden ist und der nunmehr Abfall ist, entgegen der Richtung zur Rolle 13 wegbewegt, sodass Folie 14 von der Rolle 13 gezogen wird und die Öffnung in der Matrize 12 von der Folie 14 bedeckt ist, damit ein weiteres Folienblatt 2 ausgestanzt werden kann.

Ein Transfer des Folienblatts 2 auf die Trägerplatte oder ein Justieren der Position des Folienblatts 2 auf der Trägerplatte 1 entfällt. Alternativ kann auch ein Transfer des Folienblatts 2 auf die Trägerplatte 1 unmittelbar nach dem Ausstanzen erfolgen. Das ausgestanzte Folienblatt 2 wird durch die Trägerplatte 1 gehalten, wie in Figur 1 gezeigt. Seine Position auf der Trägerplatte 1 bleibt während möglicher Zwischenschritte und während der, durch den waagerechten Pfeil angedeuteten, Bewegung der Trägerplatte 1 unverändert.

Die Anlage umfasst ferner eine Stapelform 5 oder Kaverne mit einem höhenverstellbaren Boden 4, wie in Figur 1 dargestellt. In der Stapelform 5 befinden sich die abgestapelten Folienblätter 3. Der Boden 4 kann über eine Hubeinrichtung in der Höhe schnell verstellt werden, welches ein erstes und ein zweites Hubmodul umfasst. Die Hubeinrichtung umfasst einen Servomotor 8 mit einer Spindel 7, beispielsweise einer Kugelumlaufspindel, im zweiten Hubmodul und einen Kurzhubzylinder 6, beispielsweise einen Pneumatik-Kurzhubzylinder, im ersten Hubmodul, die beide hintereinander geschaltet sind. Der Servomotor 8 und die Spindel 7 dienen als Spindelhubmodul 9, durch das der Boden 4 und der Kurzhubzylinder 6 vertikal bewegt werden können. Der Kurzhubzylinder 6 ist mit dem Boden 4 der Stapelform 5 verbunden, beispielsweise über eine Stange. Sowohl der Kurzhubzylinder 6 als auch der Servomotor 8 sind geeignet, den Boden 4 relativ zu den Seitenwänden der Stapelform 5 zu bewegen.

Die Verarbeitungsabfolge zur Herstellung eines Folienstapels kann Ausstanzen, Bedrucken, Trocknen der Bedruckung, Kontrollieren der Bedruckung mit einem Visionsystem und Abstapeln in der Stapelform 5 umfassen. Das abzustapelnde und ausgestanzte Folienblatt 2 wird nach dem Ausstanzen von der Folienrolle durch Unterdruck beziehungsweise Vakuum auf der Trägerplatte 1 festgehalten und verändert seine Position auf der Trägerplatte 1 bis zum Abstapeln in die hochgenaue Stapelform 5 nicht mehr. Damit fallen aufwändige Prozessschritte und Maßnahmen zum Ausrichten des Folienblatts 2 weg. Zentriermarken auf den Folienblättern 2 sind nicht erforderlich. Die Bewegung der Trägerplatte 1 kann auf dem Weg von der Trennvorrichtung 10, 11, 12 bis zur Stapelform 5 sowohl Translation als auch Rotation umfassen. Rotation tritt auf, wenn die Trägerplatte 1 mit dem obenauf befindlichen Folienblatt 2 um 180° beziehungsweise nahezu 180° gedreht wird, sodass das Folienblatt 2 auf den unter der Trägerplatte 1 befindlichen Stapel gelegt werden kann. Die dem Austanzen folgenden Prozessschritte können beispielsweise an einzelnen Prozessstationen (nicht dargestellt) erfolgen, zu denen die Trägerplatte 1 mit dem Folienblatt 2 bewegt wird.

In einem Ausführungsbeispiel sind eine Vielzahl von Trägerplatten 1 vorgesehen, von denen jeweils eine oder mehrere gleichzeitig an den einzelnen Prozessstationen befinden, was die Herstellungsgeschwindigkeit für den Folienstapel erhöht. Die Trägerplatten 1 werden schrittweise von der Trennvorrichtung 10, 11, 12 über die verschiedenen Prozessstationen zur Stapelform 5 bewegt, wobei die Folienblätter 2 auf den einzelnen Trägerplatten 1 in ihrer vorgegebenen Position verbleiben.

Das Abstapeln der Folienblätter 2 in die Stapelform 5 oder Kaverne ist ein zentraler Punkt. Die Abstapelform 5 verfügt über einen beweglichen Boden 4, der über die Hubeinrichtung mit Kurzhubzylinder 6 und Spindelhubmodul 9 in der Höhe schnell verstellt werden kann. Der Kurzhubzylinder 6 vollführt das Abholen des Folienblatts 2 von der Trägerplatte 1. Der Boden 4 mit den darauf abgestapelten Folienblättern 3 wird zur Trägerplatte 1 gefahren, vorteilhafterweise ohne dass der Servomotor 8 einen Betrag zu dieser Bewegung leistet. Nach dem Ablegen des Folienblatts 2 wird der Boden 4 durch den Kurzhubzylinder 6 abgesenkt. Der Auf- und Abwärtshub, d.h. die Wegstrecken, die der Boden 4 durch den Kurzhubzylinder 6 auf- und abwärts bewegt wird, sind gleich groß. Nach dem Ablegen jedes abgestapelten Folienblatts 2 korrigiert der Servomotor 8 die Position des Bodens 4 in der Stapelform 5 um die Foliendicke, um trotz zunehmender Stapelhöhe die gleichen Abstapelbedingungen zu erreichen. Dadurch ist die Stapelqualität auch bei hohen Stapeln gleichmäßig, und die Stapelung ist exakt.

Zusätzlich kann die Stapelform 5 eine schnelle Drehbewegung um 180° ausführen. Diese Drehbewegung erfolgt zwischen dem Abstapeln zweier Folienblätter 2.

Die geometrische Genauigkeit der Stapelform 5 bestimmt die Stapelgenauigkeit. Die Grundfläche des Bodens 4 entspricht der der Folienblätter 2. Auch sind die Seitenflächen der Stapelform 5 über die komplette Höhe der Stapelform 5 sehr maßgenau und mit geringer Streuung gefertigt, typischerweise besser als +/-8 µm. Ein anderes Merkmal der Stapelform 5 ist, dass die Innenkante mit einer Fase 0,05x45° bis 0,1x45° versehen wird, um das Abstapeln beziehungsweise Übergeben des Folienblatts 2 zur Stapelform 5 zu stabilisieren und prozesssicher zu gestalten.

Das Abstapeln der Folienblätter 2 erfolgt in folgender Weise: Die Trägerplatte 1, welche das Folienblatt 2 mittels Unterdruck beziehungsweise Vakuum hält, wird zum Abstapeln über die Stapelform 5 bewegt. Die Trägerplatte 1 wird mit einem konusförmigen Stift und Buchse (nicht dargestellt) positionsrichtig zentriert und mit der Stapelform 5 in Kontakt gebracht, beispielsweise indem die Trägerplatte 1 auf dem Rand der Stapelform 5 aufliegt. Anschließend wird der Boden 4 mit den eventuell schon abgestapelten Folienblättern 3 vom Kurzhubzylinder 6 soweit hochgefahren (z.B. um 3 mm), bis er mit dem abzustapelnden Folieblatt 2 in Kontakt kommt. Alternativ kann die Übergabe des Folienblatts 2 auch eingeleitet werden, indem die Trägerplatte 1 über der Stapelform 5 abgesenkt wird und gleichzeitig der Boden 4 mit Hilfe des Kurzhubzylinders 6 angehoben wird bis die abgestapelten Folienblätter 3 an das Folienblatt 2 an der Trägerplatte 1 anschlagen. Durch diesen Presskontakt einerseits und durch das Umschalten vom Plattenvakuum auf Druckluft, indem beispielsweise die Düsen vom Unterdruckbetrieb auf Druckluftausgabe umgeschaltet werden, andererseits wird das Folienblatt 2 von der Trägerplatte 1 zur Stapelform 2 prozesssicher und mit hoher Genauigkeit übergeben. Die Folienblattübergabe erfolgt durch Umschalten von Unterdruck beziehungsweise Vakuum auf Druckluft in der Trägerplatte 1 und gleichzeitiges Absenken des Bodens 4 mit dem Kurzhubzylinder 6 und Foliendickenkorrektur durch den Servomotor 8. Mit anderen Worten: Der Kurzhubzylinder 6 senkt den Boden 4 wieder, z.B. um 3 mm, ab. Zusätzlich korrigiert der Servomotor 8 die Position des Bodens 4 um die abgestapelte Foliendicke nach unten. Die Trägerplatte 1 wird wieder von der Stapelform 5 abgehoben und weitergetaktet. Optional kann auch die Stapelform 5 um 180° gedreht werden. Die nächste Trägerplatte 1 wird an die Position über die Stapelform 5 gebracht und der Ablauf beginnt von vorne, bis die gewünschte Stapelhöhe erreicht ist.

Das beschriebene Verfahren erlaubt das sichere und genaue Abstapeln auch sehr dünner Folien, beispielsweise mit einer Dicke bis hinab zu 15 µm. Die Folienformate können 4 ÷ 12 Zoll, vorzugsweise 4 ÷ 8 Zoll, betragen.

Es sei bemerkt, dass die Merkmale der Ausführungsbeispiele kombinierbar sind.

### Bezugszeichen

- 1: Trägerplatte
- 2: Folienblatt
- 3: abgestapelte Folienblätter
- 4: Boden
- 5: Stapelform
- 6: Pneumatikkurzhubzylinder
- 7: Spindel
- 8: Servomotor
- 9: Spindelhubmodul
- 10: Stanzkopf
- 11: Stanzstempel
- 12: Matrize
- 13: Folienrolle
- 14: Folie

## Patentansprüche

1. Verfahren zur Herstellung eines Folienstapels umfassend:
- Bereitstellen von Folie (14),
- Heraustrennen eines Folienblatts (2) aus der Folie (14), indem das Folienblatt (2) aus der Folie (14) auf eine Trägerplatte (1) gestanzt wird, sodass das Folienblatt (2) in einer vorgegebenen Position auf der Trägerplatte (1) positioniert wird,
- Halten des Folienblatts (2) auf der Trägerplatte (1) in der vorgegebenen Position,
- Bewegen der Trägerplatte (1) mit dem gehaltenen Folienblatt (2) über eine Stapelform (5), wobei das Folienblatt (2) in der vorgegebenen Position verbleibt,
- Bewegen eines höhenverstellbaren Bodens (4) der Stapelform (5) in Richtung der Trägerplatte (1), wobei abgestapelte Folienblätter (3) in der Stapelform (5) auf das gehaltene Folienblatt (2) zubewegt werden bis die abgestapelten Folienblätter (3) das gehaltene Folienblatt (2) berühren,
- Ablegen des Folienblatts (2) in die Stapelform (5).

2. Verfahren nach Anspruch 1, wobei das Folienblatt (2) durch Unterdruck gehalten wird.

3. Verfahren nach einem der vorhergehenden Ansprüche, wobei beim Ablegen Überdruck zwischen der Trägerplatte (1) und dem Folienblatt (2) eingebracht wird.

4. Verfahren nach einem der vorhergehenden Ansprüche, wobei der Boden (4) der Stapelform (5) nach dem Ablegen des Folienblatts (2) abgesenkt wird.

5. Verfahren nach Anspruch 4, wobei der Boden (4) nach dem Anheben um eine Wegstrecke um diese Wegstrecke sowie die Dicke des Folienblatts (2) abgesenkt wird.

6. Verfahren nach Anspruch 5, wobei ein erstes Hubmodul (6) den Boden (4) um die Wegstrecke anhebt und absenkt und ein zweites Hubmodul (9) den Boden (4) um die Dicke des Folienblatts (2) absenkt.

7. Verfahren nach einem der vorhergehenden Ansprüche, wobei die Stapelform (5) um eine Längsachse gedreht wird.

8. Anlage zur Herstellung eines Folienstapels mit
- einer Trennvorrichtung (10, 11, 12) zum Heraustrennen eines Folienblatts (2) aus einer Folie (14), indem das Folienblatt (2) aus der Folie (14) auf eine Trägerplatte (1) gestanzt wird,
- einer Stapelform (5) mit höhenverstellbarem Boden (4), dessen Grundfläche mit der des Folienblatts (2) korrespondiert,
wobei die Trägerplatte (1) geeignet ist das ausgestanzte Folienblatt (2) in einer vorgegebenen Position zu halten und bewegbar ist von der Trennvorrichtung in eine Position über der Stapelform (5),
und wobei der höhenverstellbare Boden (4) der Stapelform (5) in Richtung der Trägerplatte (1) derart bewegbar ist, dass die abgestapelte Folienblätter (3) in der Stapelform (5) auf das gehaltene Folienblatt (2) zubewegt werden bis die abgestapelten Folienblätter (3) das gehaltene Folienblatt (2) berühren.

9. Anlage nach Anspruch 8, wobei die Trägerplatte (1) ausgebildet ist, das Folienblatt (2) durch Unterdruck zu halten.

10. Anlage nach Anspruch 8 oder 9, wobei die Trägerplatte (1) ausgebildet ist, dass Folienblatt (2) durch Überdruck von der Trägerplatte (1) zu lösen.

11. Anlage nach einem der Ansprüche 8 bis 10 mit einem ersten Hubmodul (6), das geeignet ist, den Boden (4) um eine Wegstrecke anzuheben und absenken, und einem zweiten Hubmodul (9), das geeignet ist, den Boden (4) schrittweise jeweils um die Dicke des Folienblatts (2) abzusenken.

12. Anlage nach Anspruch 11, wobei das erste Hubmodul einen Kurzhubzylinder (6) und das zweite Hubmodul (9) einen Servomotor (8) umfasst.

13. Anlage nach einem der Ansprüche 8 bis 12, wobei die Stapelform (5) um eine Längsachse drehbar ist.

14. Anlage nach einem der Ansprüche 8 bis 13, wobei die Stapelform (5) eine mit einer Fase versehene Innenkante hat.

## Claims

1. Method for producing a film stack, comprising:
- providing a film (14),
- cutting out a film sheet (2) from the film (14) by the film sheet (2) being punched out of the film (14) onto a support plate (1), so that the film sheet (2) is positioned in a specified position on the support plate (1),
- holding the film sheet (2) on the support plate (1) in the specified position,
- moving the support plate (1) with the held film sheet (2) over a stack mould (5), the film sheet (2) remaining in the specified position,
- moving a height-adjustable bottom (4) of the stack mould (5) in the direction of the support plate (1), stacked film sheets (3) in the stack mould (5) being moved towards the held film sheet (2) until the stacked film sheets (3) come into contact with the held film sheet (2),
- depositing the film sheet (2) in the stack mould (5) .

2. Method according to claim 1, the film sheet (2) being held by negative pressure.

3. Method according to one of the preceding claims, positive pressure being introduced between the support plate (1) and the film sheet (2) while it is being deposited.

4. Method according to one of the preceding claims, the bottom (4) of the stack mould (5) being lowered after the depositing of the film sheet (2).

5. Method according to Claim 4, the bottom (4) being lowered after raising by a distance by this same distance and the thickness of the film sheet (2).

6. Method according to Claim 5, a first lifting module (6) raising and lowering the bottom (4) by the distance and a second lifting module (9) lowering the bottom (4) by the thickness of the film sheet (2).

7. Method according to one of the preceding claims, the stack mould (5) being rotated about a longitudinal axis.

8. System for producing a film stack, with
- a cutting device (10, 11, 12) for cutting a film sheet (2) out of a film (14), by the film sheet (2) being punched out of the film (14) onto a support plate (1),
- a stack mould (5) with a height-adjustable bottom (4), the base area of which corresponds to that of the film sheet (2),
the support plate (1) being suitable for holding the punched-out film sheet (2) in a specified position and being movable by the cutting device into a position above the stack mould (5),
and the height-adjustable bottom (4) of the stack mould (5) being movable in the direction of the support plate (1) in such a way that the stacked film sheets (3) in the stack mould (5) are moved towards the held film sheet (2) until the stacked film sheets (3) come into contact with the held film sheet (2).

9. System according to Claim 8, the support plate (1) being designed to hold the film sheet (2) by negative pressure.

10. System according to Claim 8 or 9, the support plate (1) being designed to detach the film sheet (2) from the support plate (1) by positive pressure.

11. System according to one of Claims 8 to 10, with a first lifting module (6), which is suitable for raising and lowering the bottom (4) by a distance, and a second lifting module (9), which is suitable for lowering the bottom (4) incrementally by the thickness of the film sheet (2) each time.

12. System according to Claim 11, the first lifting module comprising a short-stroke cylinder (6) and the second lifting module (9) comprising a servomotor (8) .

13. System according to one of Claims 8 to 12, the stack mould (5) being rotatable about a longitudinal axis.

14. System according to one of Claims 8 to 13, the stack mould (5) having an inner edge provided with a bevel.

## Revendications

1. Procédé de fabrication d'un empilement de films, comprenant:
- la préparation de film (14),
- la séparation d'une feuille de film (2) hors du film (14), par le fait que l'on découpe la feuille de film (2) hors du film (14) sur une plaque de support (1), de telle manière que la feuille de film (2) soit positionnée dans une position prédéterminée sur la plaque de support (1),
- le maintien de la feuille de film (2) sur la plaque de support (1) dans la position prédéterminée,
- le déplacement de la plaque de support (1) avec la feuille de film maintenue (2) au-dessus d'un moule d'empilement (5), la feuille de film (2) restant dans la position prédéterminée,
- le déplacement d'un fond réglable en hauteur (4) du moule d'empilement (5) en direction de la plaque de support (1), des feuilles de film empilées (3) dans le moule d'empilement (5) étant déplacées vers la feuille de film maintenue (2) jusqu'à ce que les feuilles de film empilées (3) touchent la feuille de film maintenue (2),
- le dépôt de la feuille de film (2) dans le moule d'empilement (5).

2. Procédé selon la revendication 1, dans lequel on maintient la feuille de film (2) par dépression.

3. Procédé selon l'une quelconque des revendications précédentes, dans lequel lors du dépôt on introduit une surpression entre la plaque de support (1) et la feuille de film (2).

4. Procédé selon l'une quelconque des revendications précédentes, dans lequel on abaisse le fond (4) du moule d'empilement (5) après le dépôt de la feuille de film (2) .

5. Procédé selon la revendication 4, dans lequel après le levage d'une course, on abaisse le fond (4) de cette course et de l'épaisseur de la feuille de film (2).

6. Procédé selon la revendication 5, dans lequel un premier module de levage (6) élève et abaisse le fond (4) de la course et un second module de levage (9) abaisse le fond (4) de l'épaisseur de la feuille de film (2).

7. Procédé selon l'une quelconque des revendications précédentes, dans lequel on fait tourner le moule d'empilement (5) autour d'un axe longitudinal.

8. Installation pour la fabrication d'un empilement de films, comprenant
- un dispositif de séparation (10, 11, 12) pour séparer une feuille de film (2) hors d'un film (14), par le fait que l'on découpe la feuille de film (2) hors du film (14) sur une plaque de support (1),
- un moule d'empilement (5) avec un fond réglable en hauteur (4), dont la surface de base correspond à celle de la feuille de film (2),
dans laquelle la plaque de support (1) est apte à maintenir la feuille de film découpée (2) dans une position prédéterminée et peut être déplacée du dispositif de séparation à une position au-dessus du moule d'empilement (5), et
dans laquelle le fond réglable en hauteur (4) du moule d'empilement (5) est déplaçable en direction de la plaque de support (1), de telle manière que les feuilles de film empilées (3) dans le moule d'empilement (5) soient déplacées vers la feuille de film maintenue (2) jusqu'à ce que les feuilles de film empilées (3) touchent la feuille de film maintenue (2).

9. Installation selon la revendication 8, dans laquelle la plaque de support (1) est configurée pour maintenir la feuille de film (2) par dépression.

10. Installation selon une revendication 8 ou 9, dans laquelle la plaque de support (1) est configurée pour détacher la feuille de film (2) de la plaque de support (1) par surpression.

11. Installation selon l'une quelconque des revendications 8 à 10, avec un premier module de levage (6), qui est apte à élever et à abaisser le fond (4) d'une course, et avec un second module de levage (9), qui est apte à abaisser le fond (4) pas à pas respectivement de l'épaisseur de la feuille de film (2).

12. Installation selon la revendication 11, dans laquelle le premier module de levage comprend un cylindre à course courte (6) et le second module de levage (9) comprend un servomoteur (8).

13. Installation selon l'une quelconque des revendications 8 à 12, dans laquelle le moule d'empilement (5) peut tourner autour d'un axe longitudinal.

14. Installation selon l'une quelconque des revendications 8 à 13, dans laquelle le moule d'empilement (5) comporte un bord intérieur muni d'un chanfrein.
